# EUROPÄISCHE PATENTSCHRIFT

(11) **EP 2 905 901 B1**
(45) Veröffentlichungstag und Bekanntmachung des Hinweises auf die Patenterteilung: **18.12.2019**
(21) Anmeldenummer: 15153534.1
(22) Anmeldetag: 03.02.2015
(51) Int. Cl.: H03K 17/955, G01R 27/26

(54) **Schaltungsanordnung und Verfahren zur Erfassung einer Kapazität und/oder einer Kapazitätsänderung eines kapazitiven Bauelements**
Circuit assembly and method for detecting a capacity and/or a change in capacity of a capacitive component
Procédé et dispositif de détermination d'une capacité et/ou d'une modification de capacité d'un élément de construction capacitif

(30) Priorität: 06.02.2014 DE 102014202216; 06.02.2014 DE 202014100536 U
(43) Veröffentlichungstag der Anmeldung: 12.08.2015
(73) Patentinhaber: Brose Fahrzeugteile GmbH & Co. Kommanditgesellschaft, Bamberg, 96052 Bamberg (DE)
(72) Erfinder: Geuther, Udo, 96049 Bamberg (DE); Daiminger, Ralf, 96050 Bamberg (DE); Russ, Detlef, 96237 Ebersdorf (DE)
(74) Vertreter: Maikowski & Ninnemann Patentanwälte Partnerschaft mbB

(56) Entgegenhaltungen:
- WO-A1-80/02600
- DE-U1- 8 901 346
- FR-A1- 2 208 121
- US-A- 5 406 137
- US-A1- 2008 012 581

## Beschreibung

Die vorliegende Erfindung betrifft eine Schaltungsanordnung und ein Verfahren zur Erfassung einer Kapazität eines kapazitiven Bauelements und/oder einer Änderung der Kapazität eines kapazitiven Bauelements gemäß den Oberbegriffen der Ansprüche 1 und 13.

Eine gattungsgemäße Schaltungsanordnung ist aus der DE 10 2006 029 120 A1 bekannt. In der hierin offenbarten Schaltungsanordnung ist eine Steuerungseinheit zur Steuerung einer monostabilen Kippschaltung vorgesehen, die mit dem kapazitiven Bauelement, z. B. einer Sensorelektrode oder einer Elektrodenanordnung aus Ansprechelektrode und Bezugselektrode, verbunden ist. Die Steuerungseinheit ist mit einem ersten Eingang der monostabilen Kippschaltung verbunden, um an die monostabile Kippschaltung Steuerungssignale zu übertragen, und das kapazitive Bauelement ist mit einem zweiten Eingang der monostabilen Kippschaltung verbunden. Durch ein Steuerungssignal wird an einem Ausgang der monostabilen Kippschaltung ein Ausgangssignal erzeugt, dessen Zeitdauer von der Kapazität des kapazitiven Bauelements abhängig ist. Über eine Umwandlungseinrichtung wird ein solches Ausgangssignal in eine Signalspannung umgewandelt, deren Verlauf zu der Zeitdauer des Ausgangssignals proportional ist. Die gewonnene Signalspannung ist somit ebenfalls proportional zu der Kapazität des kapazitiven Bauelements bzw. einer Kapazitätsänderung, so dass anhand der Signalspannung hierauf geschlossen werden kann. Die Signalspannung wird dementsprechend von einer Auswerteeinheit ausgewertet, um hieraus einen Erfassungswert zu erzeugen, der die aktuelle Kapazität und/oder eine Änderung der Kapazität des kapazitiven Bauelements anzeigt.

Eine derartige Schaltungsanordnung ist beispielsweise für eine Verstellvorrichtung für ein fremdkraftbetätigt verstellbares Schließelement eines Fahrzeugs einsetzbar, beispielsweise für eine elektromotorisch verstellbare Heckklappe oder Seitentür oder einen elektromotorisch verstellbaren Kofferraumdeckel eines Kraftfahrzeugs. Das kapazitive Bauelement wird hier beispielsweise durch eine Sensorelektrode gebildet, um hierüber berührungslos ein Bedienereignis detektieren zu können. So ändert sich durch ein Körperteil eines Nutzers im Bereich der Sensorelektrode die messbare Kapazität, so dass ein Nutzer durch das jeweilige Körperteil gezielt ein Bedienereignis auslösen kann, das über die Sensorelektrode detektiert wird und zu einer automatischen Verstellung des jeweiligen Schließelements führen soll. Eine beispielhafte Anwendung ist hierbei die Anwendung einer Sensorelektrode im Bereich eines hinteren Stoßfängers eines Kraftfahrzeugs, um über die Sensorelektrode eine Bewegung eines Fußes eines Nutzers im Bereich des Stoßfängers nach Art eines "Kicks" als ein Bedienereignis zu erkennen und in Reaktion hierauf die Heckklappe oder den Kofferraumdeckel des Kraftfahrzeugs zu öffnen. Die Verstellung des Schließelements in Form der Heckklappe oder des Kofferraumdeckels kann somit berührungslos, d. h., ohne Berühren des jeweiligen Schließelements durch den Nutzer gesteuert werden.

In der DE 10 2006 029 120 A1 ist eine Umwandlungseinrichtung mit einer Konstantstromquelle und einem Integrator in Form eines Kondensators vorgeschlagen. Über das Ausgangssignal der monostabilen Kippschaltung wird hierbei das Ein- und Ausschalten der Konstantstromquelle bzw. deren Verbindung mit dem Integrator gesteuert. In Abhängigkeit von der Dauer des Ausgangssignals, die wiederum von der Kapazität des kapazitiven Bauelements abhängt, wird somit durch die Konstantstromquelle eine Signalspannung an dem Integrator aufintegriert, also der Integrator in Form eines Kondensators aufgeladen. Die über den Integrator messbare Signalspannung wird von einer elektronischen Auswerteeinheit ausgewertet, um beispielsweise bei Überschreiten eines Schwellwertes auf das Vorliegen eines Bedienereignisses zu schließen und ein Auslösesignal zu erzeugen. Über ein derartiges Auslösesignal wäre dann beispielsweise die Verstellung eines Schließelements eines Kraftfahrzeugs steuerbar.

Das Vorgesehen einer Konstantstromquelle und deren gezielte Schaltung auf Basis des von der monostabilen Kippschaltung bereitgestellten Ausgangssignals beispielsweise über einen in der Schaltungsanordnung vorzusehenden Schalter kann aber unter Umständen schaltungstechnisch nur vergleichsweise aufwendig zu realisieren sein.

Aus der DE 102 58 417 B3 ist wiederum eine Schaltungsanordnung zum Erfassen und/oder Bestimmen der Beschaffenheit eines Mediums mit Hilfe eines kapazitiven Bauelements in Form eines Elektrodenpaares beschrieben, bei der anhand der über die beiden Elektroden messbaren Kapazität auf eine Zusammensetzung eines Mediums geschlossen wird, in das die beiden Elektroden eintauchen. Die beiden Elektroden sind hierfür mit einer monostabilen Kippschaltung, in der DE 102 58 417 B3 als monostabiler Multivibrator bezeichnet, verbunden, der in Abhängigkeit von der Kapazität an den Elektroden ein Ausgangssignal bestimmter Dauer generiert. Dieses Ausgangssignal wird über einen der monostabilen Kippschaltung nachgeordneten Tiefpassfilter geführt, um hiernach eine Signalspannung zur Verfügung zu stellen, die von einer Auswerteeinheit ausgewertet wird. Anhand des Wertes der Signalspannung kann dabei beispielsweise der Gehalt von Wasser in dem jeweiligen Medium ermittelt werden und es können unterschiedliche Medien, wie beispielsweise Dieselkraftstoff, Biodieselkraftstoff und Wasser aufgrund ihrer verschiedenen Dielektrizitätskonstanten unterschieden werden.

Bei der Schaltungsanordnung der DE 102 58 417 ist bei der Verwendung eines RC-Tiefpasses jedoch nachteilig, dass die an einem Kondensator des Tiefpasses abgreifbare Signalspannung nur zeitweise linear über die Zeit verläuft, und zwar nur so lange, wie eine an dem Tiefpass anliegende Eingangsspannung erheblich kleiner ist als die am Ausgang des Tiefpasses messbare Ausgangsspannung. Die Ausgangsspannung verläuft bei einem RC-Tiefpass mit der Zeit entlang einer e-Funktion und nähert sich folglich asymptotisch einem Maximalwert an. Gerade aber für die Detektion, ob ein Bedienereignis zum Verstellen eines Schließelements eines Fahrzeugs vorliegt, wird ein linearer Zusammenhang zwischen der Kapazität des kapazitiven Bauelements und der Signalspannung auch über größere Zeiträume bevorzugt, um damit sicher das jeweilige eventuell komplexe Bedienereignis erkennen zu können.

Eine andere Schaltungsanordnung zur Erfassung einer Kapazität eines kapazitiven Bauelements ist aus der WO 80/02600 bekannt.

Der vorliegenden Erfindung liegt damit die Aufgabe zugrunde, eine gattungsgemäße Schaltungsanordnung weiter zu verbessern und ein verbessertes Verfahren zur Erfassung einer Kapazität und/oder einer Kapazitätsänderung eines kapazitiven Bauelements bereitzustellen.

Diese Aufgabe wird mit der Schaltungsanordnung des Anspruchs 1 und einem Verfahren des Anspruchs 13 gelöst.

Bei einer erfindungsgemäßen Schaltungsanordnung ist dementsprechend vorgesehen:
- eine durch ein Steuerungssignal steuerbare monostabile Kippschaltung mit wenigstens zwei Eingängen und einem Ausgang, wobei ein erster Eingang der monostabilen Kippschaltung für das Steuerungssignal vorgesehen ist, ein zweiter Eingang mit einem kapazitiven Bauelement verbunden ist und bei einer Ansteuerung ein Ausgangssignal an dem Ausgang der monostabilen Kippschaltung erzeugt wird, dessen Zeitdauer von der Kapazität des kapazitiven Bauelements abhängig ist,
- eine Umwandlungseinrichtung, die mit dem Ausgang der monostabilen Kippschaltung verbunden ist und mit einem einen Operationsverstärker aufweisenden Integrierer dazu ausgebildet und vorgesehen ist, ein an dem Ausgang der monostabilen Kippschaltung erzeugtes Ausgangssignal in eine Signalspannung umzuwandeln, deren Verlauf zu der Zeitdauer des Ausgangssignals proportional ist und die sich linear mit der Zeit verändert,
- eine Auswerteeinheit, die mit dem Integrierer der Umwandlungseinrichtung verbunden ist, um die Signalspannung auszuwerten und hieraus wenigstens einen Erfassungswert zu erzeugen, der die Kapazität und/oder eine Änderung der Kapazität des kapazitiven Bauelements anzeigt, und
- über eine zusätzliche, schaltbare Einstellvorrichtung die Höhe der Signalspannung steuern und/oder eine Kennlinie für die Signalspannung (Ss) verändern zu können.

Durch die Verwendung eines Integrierers mit einem Operationsverstärker und mit wenigstens einem hierzu parallel geschalteten Kondensator wird an dem Ausgang des Integrierers, mit dem die Auswerteeinheit verbunden ist, eine linear verlaufende Signalspannung erzeugt, die direkt von dem Ausgangssignal der monostabilen Kippschaltung und damit von der Kapazität des kapazitiven Bauelements abhängt. Der Integrierer ist folglich erfindungsgemäß so ausgebildet und zwischen den Ausgang der monostabilen Kippschaltung und die Auswerteeinheit geschaltet, dass ein Ausgangssignal der monostabilen Kippschaltung an einem Verstärkereingang des Operationsverstärkers anliegt und zu einer sich linear mit der Zeit verändernden Signalspannung führt, wobei die Werte, die die Signalspannung annehmen kann, unmittelbar von dem Ausgangssignal abhängig und durch das Ausgangssignal vorgegeben sind

Im Unterschied zu der Schaltungsanordnung der DE 10 2006 069 120 A1 ist somit zwischen der monostabilen Kippschaltung und der Umwandlungseinrichtung kein über das Ausgangssignal der Kippschaltung schaltbares Schaltglied vorgesehen, sondern das Ausgangssignal wird direkt dem Operationsverstärker des Integrierers zugeführt, um hiermit die Signalspannung zu erzeugen. Darüber hinaus wird bei der erfindungsgemäßen Lösung auch keine Schaltung einer Konstantstromquelle durch das Ausgangssignal vorgesehen, um dann unabhängig von dem Spannungswert des Ausgangssignals mit Hilfe der Konstantstromquelle an einem Integrator eine Signalspannung zu erzeugen. Die erfindungsgemäße Lösung geht vielmehr von dem Grundgedanken aus, das Ausgangssignal der monostabilen Kippschaltung direkt weiterzuverarbeiten und vorzugsweise auch über dessen Spannungswerte die Werte, die die Signalspannung annehmen kann, vorzugeben.

Dementsprechend wird in einer bevorzugten Ausführungsvariante vorgesehen, dass die monostabile Kippschaltung derart ausgebildet ist, dass ihr Ausgangssignal zwei diskrete Spannungswerte annehmen kann. Beispielsweise variiert der Spannungswert des Ausgangssignals zwischen 0V und einem positiven Spannungswert, beispielsweise in Höhe von 5V, 10V oder 15V.

Die Höhe der Signalspannung kann in der erfindungsgemäß mit einem Operationsverstärker ausgebildeten Schaltungsanordnung steuerbar sein, vorzugsweise über eine von dem Ausgangssignal unabhängige elektronische Einstellvorrichtung stufenlos oder in vordefinierten Stufen. Derart kann beispielsweise ein durch den Integrierer vorgegebener Verstärkungsfaktor einstellbar sein. Bei Bedarf und je nach Einsatzzweck, gewünschter Sensitivität, Ansprechschwelle und/oder Umgebungsbedingungen kann somit ein Verstärkungsfaktor zwischen Ausgangssignal und Signalspannung angepasst und eine Kennlinie für die auszuwertende Signalspannung verändert werden.

In einer Ausführungsvariante wird hierfür der an einen Eingang des Operationsverstärkers zurückgeführte Strom mithilfe einer elektronischen Einstellvorrichtung verändert. Hierdurch lässt sich die Steilheit einer Kennlinie für die Signalspannung in einfacher Weise gezielt verändern, insbesondere die Kennlinie verkippen.

In einem Ausführungsbeispiel ist eine schaltbare Einstellvorrichtung vorgesehen, über die mehrere diskrete Werte für einen Verstärkungsfaktor vorgegeben und auswählbar sind. Über verschiedene Schaltzustände der Einstellvorrichtung können hierbei verschiedene Verstärkungsfaktoren vorgegeben werden. Durch einen veränderten Verstärkungsfaktor erfolgt in einem möglichen Ausführungsbeispiel auch eine Veränderung der Höhe der Signalspannung, insbesondere eine Veränderung eines möglichen, von dem Ausgangssignal unmittelbar abhängigen Maximalwerts der Signalspannung und hiermit wiederum eine Adaption einer Kennlinie für die Signalspannung. Beispielsweise weist eine Einstellvorrichtung wenigstens ein Schaltmittel in Form eines Feldeffekttransistors, vorzugsweise wenigstens zwei Feldeffekttransistoren auf, um elektrisch gesteuert verschiedene Schaltzustände einnehmen zu können.

Weiterhin wird es bevorzugt, wenn das Ausgangssignal der monostabilen Kippschaltung an einem Verstärkereingang des Operationsverstärkers anliegt und das - vorzugsweise zwischen einem Minimalwert und einem Maximalwert variierende - Ausgangssignal
- einen Minimalwert aufweist, der kleiner ist als ein Spannungswert einer Bezugsspannung, die an dem anderen Verstärkereingang des Operationsverstärkers anliegt, und
- einen Maximalwert aufweist, der größer ist als der Spannungswert der Bezugsspannung an dem anderen Verstärkereingang.

Ein Ausgangssignal kann hier folglich zwei unterschiedliche Zustände abbilden und dementsprechend zwei unterschiedliche Spannungen an einem Verstärkereingang des Operationsverstärkers vorgeben, von denen eine Spannung unterhalb und die andere Spannung oberhalb der an dem anderen Verstärkereingang anliegenden Bezugsspannung liegt. In dieser Konfiguration wird mit einem zu dem Operationsverstärker parallel geschalteten Kondensator, der einerseits mit dem Verstärkereingang verbunden ist, an dem das Ausgangssignal anliegt, und andererseits mit dem Ausgang des Operationsverstärkers verbunden ist, am Ausgang des Operationsverstärkers ein linear ansteigendes oder linear abfallendes Spannungssignal erzeugt, je nachdem, ob die Spannung des Ausgangssignals über oder unterhalb der Bezugsspannung liegt. Hierdurch ist besonders einfach und effektiv ein Rückschluss auf die Kapazität des kapazitiven Bauelements möglich. Da die Dauer des Ausgangssignals mit einem bestimmten Spannungswert unmittelbar von der Kapazität des kapazitiven Bauelements abhängt, ist auch die Dauer des linearen Anstiegs oder Abfalls der Signalspannung stets unmittelbar von der Kapazität des kapazitiven Bauelements abhängig.

Im Hinblick auf eine möglichst ökonomische Schaltungsanordnung wird es bevorzugt, dass zum Betrieb des Operationsverstärkers eine Versorgungsspannung vorgesehen ist und die Schaltungsanordnung einen Spannungsteiler aufweist, um eine Bezugsspannung, die an einem Verstärkereingang des Operationsverstärkers anliegt, als eine Teilspannung dieser Versorgungsspannung bereitzustellen. Damit kann an einer Stelle der Schaltungsanordnung die Versorgungsspannung angelegt werden und hieran nicht nur ein Versorgungsanschluss des Operationsverstärkers angeschlossen werden, sondern auch über einen Spannungsteiler einer der Verstärkereingänge des Operationsverstärkers. Wie allgemein bekannt wird ein solcher Spannungsteiler bevorzugt durch zwei Widerstände gebildet.

In einer bevorzugten Ausführungsvariante ist der mit dem Operationsverstärker definierte Integrierer einer erfindungsgemäßen Schaltungsanordnung invertierend ausgestaltet. Dementsprechend liegt hier das Ausgangssignal an dem invertierendem (negativen) Verstärkereingang des Operationsverstärkers an und die Bezugsspannung an dem nicht-invertierendem (positiven) Verstärkereingang. Es ist aber selbstverständlich möglich, auch einen nicht-invertierendem Integrierer zu verwenden, wodurch sich beispielsweise bei gleichbleibenden, zwischen zwei Spannungswerten variierenden Ausgangssignalen lediglich lineare Verläufe für die Signalspannung ergeben, die zu den Verläufen der Signalspannung bei einem invertierendem Integrierer umgekehrt sind.

Im Hinblick auf die Auswertung der erzeugten Signalspannung wird es in einem Ausführungsbeispiel bevorzugt, dass dem Integrierer ein Spitzenwerthaltglied nachgeschaltet ist, um einen maximalen Spannungswert für die Signalspannung (für das soeben an die monostabile Kippschaltung gegebene Steuerungssignal) zu speichern. Der gehaltene bzw. gespeicherte maximale Spannungswert kann dann beispielsweise mit einem in der Auswerteeinheit hinterlegten Schwellwert für die Signalspannung verglichen werden, um zu bewerten, ob dieser Schwellwert unter- oder überschritten wurde.

Wird ein Über- oder Unterschreiten des Schwellwerts festgestellt, kann die Auswerteeinheit beispielsweise ein Auslösesignal erzeugen, um zu signalisieren, dass die Kapazität des kapazitiven Bauelements einen als relevant eingestuften Kapazitätswert unterschritten oder überschritten hat bzw. eine entsprechenden Kapazitätsänderung aufgetreten ist. Ein solches Auslösesignal kann beispielsweise das Vorliegen eines Bedienereignisses zur Verstellung eines Schließelements an einem Fahrzeug anzeigen.

Bei dem an dem Spitzenwerthaltglied gespeicherten maximalen Spannungswert kann es sich somit um einen Erfassungswert handeln, der die Kapazität und/oder eine Änderung der Kapazität des kapazitiven Bauelements anzeigt, so dass das Spitzenwerthalteglied hier Teil einer (elektronischen) Auswerteeinheit darstellt. Alternativ oder ergänzend kann selbstverständlich auch die Signalspannung direkt an eine elektronische Auswerteeinheit übertragen werden. Die Auswerteeinheit ist hierbei beispielsweise dazu in der Lage, anhand des Signalverlaufs, insbesondere zum Beispiel anhand der Dauer eines linearen Anstiegs oder Abfalls der Signalspannung bis zum Über- und/oder Unterschreiten eines Schwellwerts oder sogar mehrerer Schwellwerte einen Erfassungswert oder mehrere Erfassungswerte zu gewinnen. Ein Erfassungswert kann beispielsweise einer nachgeschalteten Steuerungseinrichtung eine Kapazität des kapazitiven Bauelements und/oder eine Kapazitätsänderung anzeigen. So kann es sich bei dem Erfassungswert auch um einen Wert handeln, der von der Auswerteeinheit generiert wird, um einen bestimmten Kapazitätswert und/oder eine Kapazitätswertänderung bei dem kapazitiven Bauelement qualitativ oder quantitativ anzuzeigen.

In einer beispielhaften Schaltungsanordnung umfasst das Spitzenwerthalteglied, das mit dem Ausgang des Integrierers verbunden ist, wenigstens eine Diode und einen Speicherkondensator. Es ist selbstverständlich möglich, dass der an dem Spitzenwerthalteglied gehaltene maximale Spannungswert nicht identisch zu einem Maximalwert der an dem Ausgang des Integrierers erzeugten Signalspannung ist. So können beispielsweise in der Schaltungsanordnung noch zusätzliche Widerstände vorgesehen sein, so dass die an dem Speicherkondensator des Spitzenwerthalteglieds mithilfe der Diode gehaltene Spannung geringer ist als die am Ausgang des Integrierers erzeugte Signalspannung. Die an dem Speicherkondensator des Spitzenwerthalteglieds anliegende Spannung ist aber im jeden Fall proportional zu der Signalspannung.

Wie bereits eingangs erläutert, ist ein weiterer Aspekt der vorliegenden Erfindung die Bereitstellung einer erfindungsgemäßen Schaltungsanordnung in einer Verstellvorrichtung für ein verstellbares Schließelement eines Fahrzeugs.

Bei einer derartigen Verstellvorrichtung ist über das Schließelement eine Karosserieöffnung eines Fahrzeugs verschließbar und das Schließelement kann zum Freigeben der Karosserieöffnung bei Vorliegen eines Bedienereignisses automatisch verstellbar sein. Alternativ oder ergänzend kann bei Vorliegen eines Bedienereignisses eine Verriegelung des Schließelements betätigbar sein, um das Schließelement freizugeben und überhaupt erst (manuell oder fremdkraftbetätigt) verstellen zu können. Beispielsweise handelt es sich bei dem Schließelement um eine Heckklappe oder eine (Seiten-)Tür eines Kraftfahrzeugs oder einen Kofferraumdeckel eines Kraftfahrzeugs. Über eine kapazitiv arbeitende Sensoreinrichtung mit wenigstens einem kapazitiven Bauelement, zum Beispiel in Form einer einzelnen Sensorelektrode oder wenigstens einem Sensorelektrodenpaar, wird hierbei das Vorliegen eines Bedienereignisses anhand der Kapazität des Bauelements und/oder einer Änderung der Kapazität des Bauelements erkannt.

Ein weiterer Aspekt der vorliegenden Erfindung ist ein Verfahren zur Erfassung einer Kapazität und/oder einer Änderung der Kapazität eines kapazitiven Bauelements, bei dem wenigstens die nachfolgenden Schritte vorgesehen sind:
- Steuern einer monostabilen Kippschaltung durch Anlegen eines Steuerungssignals, das beispielsweise von einer elektronisches Steuerungseinheit bereitgestellt wird, an einem ersten Eingang der monostabilen Kippschaltung, wobei die monostabile Kippschaltung an einem zweitem Eingang mit dem kapazitiven Bauelement verbunden ist,
- Erzeugen wenigstens eines Ausgangssignals an einem Ausgang der monostabilen Kippschaltung bei Anlegen des Steuerungssignals, wobei die Zeitdauer des erzeugten Ausgangssignals von der Kapazität des kapazitiven Bauelements abhängig ist, und
- Umwandeln des wenigstens einen Ausgangssignals in eine Signalspannung, deren Verlauf zu der Zeitdauer des Ausgangssignals proportional ist.

In Analogie zu einer erfindungsgemäßen Schaltungsanordnung ist bei einem erfindungsgemäßen Verfahren vorgesehen, dass das Umwandeln des Ausgangssignals mittels eines Integrierers erfolgt, der einen Operationsverstärker aufweist, an dessen einem Verstärkereingang das Ausgangssignal anliegt, und der das Ausgangssignal der monostabilen Kippschaltung zu einer sich linear mit der Zeit verändernden Signalspannung umwandelt, so dass die Werte, die die Signalspannung annehmen kann, durch das Ausgangssignal vorgegeben sind. Ferner ist wird erfindungsgemäß eine Möglichkeit zur Steuerung der Höhe der Signalspannung und/oder zur Veränderung eine Kennlinie für die Signalspannung mittels einer schaltbaren Einstellvorrichtung vorgesehen, so dass beispielsweise ein durch den Integrierer vorgegebener Verstärkungsfaktor zwischen Ausgangssignal und Signalspannung stufenlos oder in vordefinierten Stufen einstellbar ist, um diesen bei Bedarf und je nach Einsatzzweck, gewünschter Sensitivität, Ansprechschwelle und/oder Umgebungsbedingungen ohne Weiteres gezielt anzupassen und gegebenenfalls eine Kennlinie für die auszuwertende Signalspannung zu verändern.

Es ist somit offensichtlich, dass die zuvor und nachfolgend noch erläuterten Vorteile und Merkmale von Ausführungsbeispielen einer Schaltungsanordnung auch für ein Verfahren zur Erfassung einer Kapazität und/oder einer Veränderung der Kapazität eines kapazitiven Bauelements gelten und umgekehrt.

Bei der nachfolgenden Beschreibung eines Ausführungsbeispiels anhand der Figuren werden weitere Vorteile und Merkmale der vorliegenden Erfindung deutlich werden.

Hierbei zeigen:
- Fig. 1: einen Ausschnitt eines Ausführungsbeispiels für eine Schaltungsanordnung mit einem einen Operationsverstärker aufweisenden invertierenden Integrierer und einem Spitzenwerthalteglied;
- Fig. 2: eine erfindungsgemäße Weiterbildung des Ausführungsbeispiels der Figur 1 mit einer Einstellvorrichtung zur Vorgabe unterschiedlicher Verstärkungsfaktoren an dem Integrierer;
- Fig. 3: eine aus dem Stand der Technik bekannte Schaltungsanordnung.

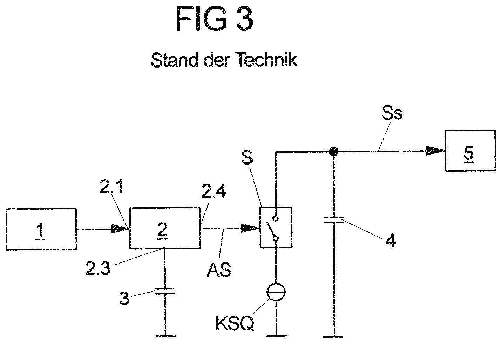

Zunächst Bezug nehmend auf die Figur 3 wird ein aus der DE 10 2006 029 120 A1 vorbekanntes Ausführungsbeispiel einer gattungsgemäßen Schaltungsanordnung veranschaulicht, bei der eine Umwandlungseinrichtung mit einem Schalter S, einer Konstantstromquelle KSQ und einem Integrator 4 vorgesehen ist.

Bei dem aus dem Stand der Technik bekannten Ausführungsbeispiel einer Schaltungsanordnung gemäß der Figur 3 wird von einer elektronischen Steuereinheit 1 ein Steuerungssignal generiert und an eine monostabile Kippschaltung 2 übertragen. Hierfür ist die Steuereinheit 1 mit einem ersten Eingang 2.1 der Kippschaltung 2 verbunden. An einem zweiten Eingang 2.3 ist die monostabile Kippschaltung 2 mit einem kapazitiven Bauelement 3 verbunden. Dieses kapazitive Bauelement ist vorliegend in Form einer Sensorkapazität 3 gezeigt und kann beispielsweise eine Sensorelektrode eines kapazitiven Näherungsschalters sein oder einen Sensorkondensator mit einer Ansprechelektrode und einer Bezugselektrode umfassen.

Mittels der monostabilen Kippschaltung 2 wird an einem Ausgang 2.4 der Kippschaltung 2 in Folge eines Steuerungssignals der Steuereinheit 1 wenigstens ein Ausgangssignal AS erzeugt, dessen Zeitdauer von der Kapazität bzw. der Größe der Sensorkapazität 3 abhängig ist. Dieses Ausgangssignal AS wird bei der aus dem Stand der Technik bekannten Schaltungsanordnung zur Steuerung eines Schalters S genutzt, um eine Konstantstromquelle KSQ für die Dauer des Ausgangssignals an einen Integrator 4 in Form eines Kondensators anzuschließen. Über die Konstantstromquelle KSQ wird der Integrator 4 aufgeladen, wobei die über dem Integrator 4 aufintegrierte Spannung als eine Signalspannung Ss von einer elektronischen Auswerteeinheit 5 ausgewertet wird. Die Signalspannung Ss ist zu der Zeitdauer des Ausgangssignals AS proportional und verläuft aufgrund der Konstantstromquelle KSQ linear über die Zeit. Die Signalspannung Ss ist damit repräsentativ für die Größe der Sensorkapazität 3 beziehungsweise die Kapazität und/oder eine Änderung der Kapazität eines hiermit gebildeten Sensorkondensators. Nach dem Abschluss einer Messung ist jeweils ein Entladevorgang vorgesehen.

Die Auswerteeinheit 5 kann somit aus der Signalspannung Ss einen Erfassungswert bilden, der die Größe der Sensorkapazität 3 quantitativ und/oder die eine Veränderung der Sensorkapazität 3 qualitativ anzeigt. In der Auswerteeinheit 5 ist beispielsweise wenigstens ein Schwellwert hinterlegt, dessen Über- oder Unterschreiten durch die Signalspannung Ss die Erzeugung eines Auslösesignals hervorruft. Ein solches Auslösesignal könnte das Vorliegen eines Bedienereignisses anzeigen, auf das hin eine fremdkraftbetätigte. dass heißt, insbesondere über einen Antriebsmotor angetriebene, Verstellung eines Schließelements eines Fahrzeugs erfolgt. Beispielsweise kann bei Vorliegen eines bestimmten durch die Sensorkapazität 3 sensierten Bedienereignisses ein Öffnen oder Schließen einer Heckklappe oder einer Seitentür und/oder eines Kofferraumdeckels eines Kraftfahrzeugs ausgelöst werden.

Anstatt die Konstantstromquelle KSQ über den Schalter S selektiv in Abhängigkeit von dem Auslösesignal AS mit dem Integrator 4 zu verschalten, kann alternativ auch vorgesehen sein, dass die Konstantstromquelle KSQ direkt über das Auslösesignal AS ein- und ausgeschaltet wird.

Die aus der DE 10 2006 029 120 A1 bekannte Schaltungsanordnung gemäß der Figur 3 mit einem durch das Auslösesignal AS steuerbarem Schaltglied, beispielsweise dem Schalter S und der Erzeugung einer Signalspannung Ss, die unabhängig von der Höhe einer durch das Ausgangssignal AS der monostabilen Kippschaltung 2 bereitgestellten Spannung ist, ist insbesondere im Hinblick auf die Bereitstellung einer Konstantstromquelle KSQ unter Umständen schaltungstechnisch vergleichsweise aufwendig zu realisieren.

Mit der erfindungsgemäßen Lösung werden eine verbesserte Schaltungsanordnung und ein verbessertes Verfahren zur Erfassung einer Kapazität und/oder einer Änderung der Kapazität eines kapazitiven Bauelements wie der Sensorkapazität 3 bereitgestellt.

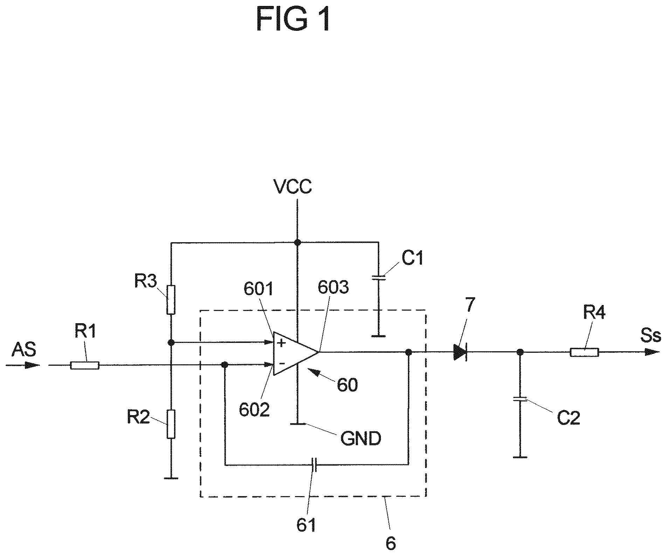

In der Figur 1 ist ein Ausführungsbeispiel einer Schaltungsanordnung dargestellt, bei der eine Umwandlungseinrichtung zur Umwandlung des Ausgangssignals AS der monostabilen Kippschaltung 2 in eine Signalspannung Ss für die Auswerteeinheit 5 einen invertierenden Integrierer 6 mit einem Operationsverstärker 60 umfasst. Die Werte, die die Signalspannung Ss in dieser Schaltungsanordnung annehmen kann, sind unmittelbar durch das Ausgangssignal AS vorgegeben.

Das Ausgangssignal AS wird hierbei über einen Widerstand R1 direkt auf einen invertierenden (negativen) Verstärkereingang 602 des Operationsverstärkers 60 gegeben. An dem anderen nicht-invertierenden (positiven) Verstärkereingang 601 des Operationsverstärkers 60 liegt eine Bezugsspannung an, die sich als Teilspannung einer Versorgungsspannung VCC ergibt. Hierfür ist ein durch zwei in Reihe geschaltete Widerstände R2 und R3 gebildeter Spannungsteiler vorgesehen, durch den an dem nicht invertierendem Verstärkereingang 601 nur ein Bruchteil der Versorgungsspannung VCC, zum Beispiel 1/2 VCC, anliegt. Die gegenüber Erde GND angegebene Versorgungsspannung VCC dient ferner auch der Versorgung des Operationsverstärkers 60 und ist folglich mit dessen Versorgungsanschluss verbunden. Zusätzlich ist ein Speicherkondensator C1 vorgesehen, der gegen Erde GND an der Versorgungsspannung VCC anliegt. Über diesen optionalen Speicherkondensator C1 wird eine Stabilisierung der Betriebsspannung, insbesondere für den Operationsverstärker 60 erreicht.

Zu dem Operationsverstärker 60 ist ferner eine Kapazität 61 in an sich bekannter Weise parallel geschaltet und hierfür sowohl mit einem Ausgang 603 des Operationsverstärkers 60 als auch mit dem invertierendem Verstärkereingang 602 verbunden, an dem das Ausgangssignal AS anliegt.

Die monostabile Kippschaltung 2 ist hier so ausgeführt, dass in Folge eines Steuerungssignals an ihrem ersten Eingang 2.1 ein Ausgangssignal AS mit einem maximalen (konstanten) Spannungswert >0V, zum Beispiel 5V, erzeugt wird. In Abhängigkeit von der Größe der Sensorkapazität 3 liegt dieses Ausgangssignal AS mit seinem Maximalwert (High-Pegel) für eine bestimmte Dauer an dem invertierenden Verstärkereingang 602 an. Die Bezugsspannung an dem nicht invertierendem Verstärkereingang 601 ist nun so gewählt, dass sie kleiner ist als der maximale Spannungswert des Ausgangssignals AS, beispielsweise in etwa die Hälfte des Maximalwert des Ausgangssignals AS beträgt, also zum Beispiel 2,5V. Dementsprechend wird an dem Verstärkerausgang 603 eine linear über die Zeit abfallende Signalspannung Ss erzeugt, die bis auf 0V absinken kann, je nachdem, wie lange das Ausgangssignal AS mit dem maximalen Spannungswert anliegt.

Das Ausgangssignal As kann neben seinem Maximalwert auch einen diskreten Minimalwert (Low-Pegel) annehmen, dessen Dauer ebenfalls von der Größe der Sensorkapazität 3 abhängt. Dieser Minimalwert ist vorliegend 0V, so dass somit folglich an dem invertierendem Verstärkereingang 602 eine kleinere Spannung anliegt als an dem nicht-invertierendem Verstärkereingang 601, an dem stets die konstante Bezugsspannung anliegt, die größer ist als der Minimalwert des Ausgangssignals AS (>0 V) und gleichzeitig kleiner als der Maximalwert des Ausgangssignals AS (< 5V). Für eine Bezugspannung V_{Bezug} gilt hier somit zum Bespiel 0V < V_{Bezug} < 5V.

An dem Verstärkerausgang 603 wird in dieser Konstellation eine linear über die Zeit ansteigende Signalspannung Ss erzeugt, deren Dauer ebenfalls direkt proportional zur Dauer des Ausgangssignals AS mit dem Minimalwert und damit abhängig von der Größe der Sensorkapazität 3 ist. Anhand der derart über den Integrierer 6 mit dem Operationsverstärker 60 erzeugten Signalspannung Ss kann somit durch die Auswerteeinheit 5 direkt auf die Größe der Sensorkapazität 3 und/oder eine Änderung der Sensorkapazität 3 qualitativ und/oder quantitativ geschlossen werden.

Im vorliegenden Fall wird sich das Ausgangssignal AS mit dem Minimalwert von hier 0V und der sich daraus ergebenden linear ansteigenden Signalspannung Ss zunutze gemacht, um auf das Vorliegen eines bestimmten Bedienereignisses zu schließen. Dabei wird das Vorliegen eines bestimmten Bedienereignisses detektiert, wenn die Signalspannung Ss ausreichend Zeit hat, über einen Schwellwert hinaus anzusteigen. Das Ausgangssignal AS der monostabilen Kippschaltung 2 mit dem minimalen (gleichbleibenden) Spannungswert von 0V liegt hier also solange an dem Operationsverstärker 60 an, dass die an dem Verstärkerausgang 603 erzeugte Signalspannung Ss über eine durch den Schwellwert definierte Ansprechschwelle hinaus linear ansteigt, was als das Vorliegen eines Bedienereignisses bewertet wird. In Folge des Detektierens dieses Bedienereignisses wird vorliegend bevorzugt ein Auslösesignal durch die Auswerteeinheit 5 erzeugt, um hier ein nicht dargestelltes Schließelement, wie zum Beispiel eine Heckklappe oder einen Kofferraumdeckel eines Kraftfahrzeugs, fremdkraftbetätigt zu öffnen oder zu schließen. Eine über die Sensorkapazität 3 detektierte Änderung eines Kapazitätswertes, die repräsentativ für das Vorliegen eines Bedienereignisses ist, kann dabei beispielsweise durch die Annäherung eines Körperteils eines Benutzer an die Sensorkapazität 3 hervorgerufen worden sein.

Um bei der Schaltungsanordnung der Figur 1 den linearen Anstieg der Signalspannung Ss effektiv auswerten zu können, ist ein Spitzenwerthalteglied vorgesehen, dass vorliegend durch eine Diode 7 und einen Speicherkondensator C2 sowie einen in Reihe geschalteten Widerstand R4 gebildet wird. Der Speicherkondensator C2 wird von der Signalspannung Ss aufgeladen, wobei die zwischen dem Verstärkerausgang 603 und dem Speicherkondensator C2 geschaltete Diode 7 verhindert, dass sich der Speicherkondensator C2 über den Operationsverstärker 60 entlädt. Proportional zu der am Verstärkerausgang 603 erzeugten Signalspannung Ss wird der Speicherkondensator C2 aufgeladen und hält einen erreichten maximalen Spannungswert, da eine Entladung durch die Diode 7 verhindert ist. Die über den Speicherkondensator C2 messbare Signalspannung stellt somit stets einen Maximalwert dar, der repräsentativ für die maximal erreichte Signalspannung Ss ist. Die an dem Speicherkondensator C2 gehaltene bzw. gespeicherte Spannung kann somit ausgewertet und mit wenigstens einem in der Auswerteeinheit 5 hinterlegten Schwellwert verglichen werden, anhand dessen Überschreitens von dem Vorliegen eines Bedienereignisses ausgegangen wird.

Mit der Schaltungsanordnung der Figur 1 ist eine besondere einfache Möglichkeit zum Erfassen einer Kapazität und/oder einer Kapazitätsänderung eines kapazitiven Bauelements, wie der Sensorkapazität 3, möglich, wobei hier unmittelbar die Spannungswerte eines von der monostabilen Kippschaltung 2 erzeugten Ausgangssignals AS die minimal und maximal erreichbaren Spannungswerte einer hieraus gewonnenen Signalspannung Ss vorgeben und zudem ein linearer Verlauf der sich durch die Ausgangsspannung AS ergebenen Signalspannung Ss erreicht wird.

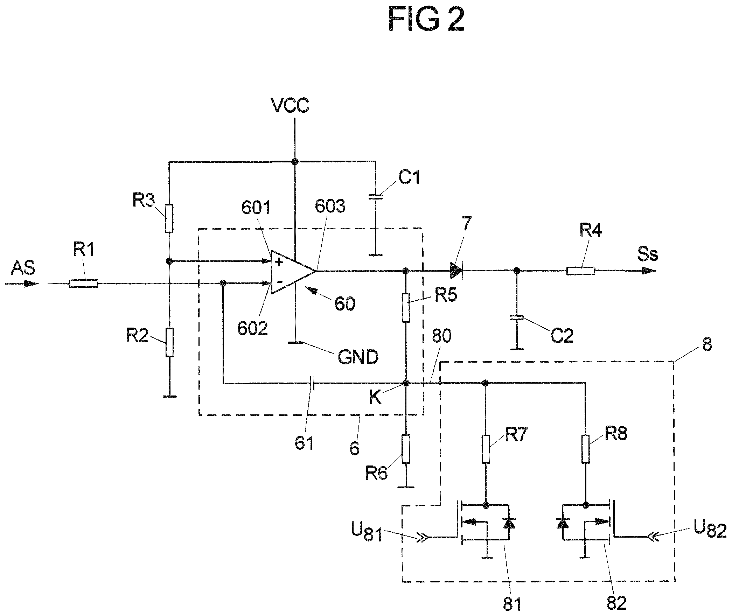

In der Figur 2 ist eine erfindungsgemäße Weiterbildung der in der Figur 1 dargestellten Schaltungsanordnung dargestellt, bei der ein Verstärkungsfaktor des Integrierers 6 einstell- und veränderbar ist. Dabei kann durch eine Veränderung des Verstärkungsfaktors eine Kennlinie der Signalspannung Ss angepasst werden, d.h., vorliegend deren Steilheit angepasst werden.

Die Schaltungsanordnung der Figur 1 ist hierbei am Ausgang des Operationsverstärkers 60 um einen Spannungsteiler mit Widerständen R5 und R6 sowie einer Einstellvorrichtung 8 ergänzt, mit der variabel Widerstände R7 und R8 zu dem einen Widerstand R6 parallel geschaltet werden können. Über die Einstellvorrichtung 8 kann somit das Potential an einem Knoten K verschoben werden, der zwischen den Widerständen R5 und R6 liegt und an dem eine Leitung zu der Kapazität 61 des Integrierers 6 sowie eine Anschlussleitung 80 der Einstellvorrichtung 8 angeschlossen ist. Derart kann der an den Operationsverstärker 60 zurückgeführte Strom variiert werden, je nachdem, welcher Gesamtwiderstand zu dem Widerstand R5 in Reihe geschaltet ist.

Die Einstellvorrichtung 8 kann vorliegend mehrere unterschiedliche Schaltzustände einnehmen, in denen jeweils ein anderer Gesamtwiderstand zu dem Widerstand R5 in Reihe geschaltet ist. Die unterschiedlichen Schaltzustände werden vorliegend über zwei MOSFETs 81 und 82 (MOSFET=Metall-Oxid-Halbleiter-Feldeffekttransistor) vorgegeben. Durch die an dem jeweiligen MOSFET 81 und 82 angelegte Gate-Source- bzw. Steuerspannung U₈₁ oder U₈₂ kann der über den jeweils zugeordneten Widerstand R7 oder R8 fließenden Strom gesteuert werden, wodurch der zu dem Widerstand R5 in Reihe geschaltete Gesamtwiderstand in seiner Größe gezielt veränder- und steuerbar ist. Hierdurch kann auf einfache Weise ein Maximalwert für die Signalspannung Ss variiert, z.B. zwischen 2,5V und 3,5V herauf- oder herabgesetzt und damit die Steilheit der Signalspannung Ss angepasst werden. Ein Schaltzustand der Einstellvorrichtung 8 ist hierbei - im Unterschied zu der Signalspannung Ss - nicht unmittelbar von dem Ausgangssignal AS abhängig, sondern hiervon unabhängig und frei, je nach Bedarf und insbesondere (aktuellem) Verwendungszweck oder Umgebungsbedingungen der Schaltungsanordnung auswählbar.

Die MOSFETs 81 und 82 werden in dem Ausführungsbeispiel der Figur 2 über die Steuerspannungen U₈₁ und U₈₂ so betrieben, dass die Einstellvorrichtung 8 vier diskrete Schaltzustände einnehmen kann. In dem jeweiligen Schaltzustand sind beide, nur einer oder keiner der MOSFETs 81 und 82 aktiv geschaltet.

Obwohl in den Ausführungsbeispielen der Figuren 1 und 2 ein invertierender Integrierer 6 vorgesehen ist, ist es selbstverständlich möglich, stattdessen einen nicht-invertierenden Integrierer einzusetzen. Hierbei würde dann selbstverständlich die in der Auswerteeinheit 5 hinterlegte Auswertelogik angepasst, d.h. ebenfalls invertiert werden.

### Bezugszeichenliste

- 1: Steuereinheit
- 2: Kippschaltung
- 2.1, 2.3: Eingang
- 2.4: Ausgang
- 3: Sensorkapazität
- 4: Integrator
- 5: Auswerteeinheit
- 6: Integrierer
- 60: Operationsverstärker
- 601, 602: Verstärkereingang
- 603: Verstärkerausgang
- 61: Kapazität
- 7: Diode
- 8: Einstellvorrichtung
- 80: Anschlussleitung
- 81, 82: MOSFET (Feldeffekttransistor)
- AS: Ausgangssignal
- C1: Speicherkondensator
- C2: Speicherkondensator
- GND: Erde
- K: Knoten
- KSQ: Konstantstromquelle
- R1 - R8: Widerstand
- S: Schalter
- Ss: Signalspannung
- U₈₁, U₈₂: Steuerspannung
- VCC: Versorgungsspannung

## Patentansprüche

1. Schaltungsanordnung zur Erfassung einer Kapazität eines kapazitiven Bauelements und/oder einer Änderung der Kapazität eines kapazitiven Bauelements, mit
- einer durch ein Steuerungssignal steuerbaren monostabilen Kippschaltung (2) mit wenigstens zwei Eingängen (2.1, 2.3) und einem Ausgang (2.4), wobei ein erster Eingang (2.1) der Kippschaltung (2) für das Steuerungssignal vorgesehen ist,
- einem kapazitiven Bauelement (3), das mit einem zweiten Eingang (2.3) der monostabilen Kippschaltung (2) verbunden ist,
- einer Umwandlungseinrichtung, die mit dem Ausgang (2.4) der monostabilen Kippschaltung (2) verbunden und dazu ausgebildet und vorgesehen ist, ein an dem Ausgang (2.4) erzeugtes Ausgangssignal (AS) in eine Signalspannung (Ss) umzuwandeln, und
- einer Auswerteeinheit (5), die mit der Umwandlungseinrichtung verbunden ist, um die Signalspannung (Ss) auszuwerten und hieraus wenigstens einen Erfassungswert zu erzeugen, der die Kapazität und/oder eine Änderung der Kapazität des kapazitiven Bauelements (3) anzeigt,
wobei die monostabile Kippschaltung (2) dazu ausgebildet ist, bei einer Ansteuerung mit einem Steuerungssignal wenigstens ein Ausgangssignal (AS) an ihrem Ausgang (2.4) zu erzeugen, dessen Zeitdauer von der Kapazität des kapazitiven Bauelements (3) abhängig ist, und die Umwandlungseinrichtung das wenigstens eine Ausgangssignal (AS) in eine Signalspannung (Ss) umwandelt, deren Verlauf zu der Zeitdauer des Ausgangssignals (AS) proportional ist,
wobei die Umwandlungseinrichtung einen Integrierer (6) mit einem Operationsverstärker (60) umfasst und der Integrierer (6) so ausgebildet und zwischen den Ausgang (2.4) der monostabilen Kippschaltung (2) und die Auswerteeinheit (5) geschaltet ist, dass ein Ausgangssignal (AS) der monostabilen Kippschaltung (2) an einem Verstärkereingang (602) des Operationsverstärkers (60) anliegt und zu einer sich linear mit der Zeit verändernden Signalspannung (Ss) führt, wobei die Werte, die die Signalspannung (Ss) annehmen kann, durch das Ausgangssignal (AS) vorgegeben und von dem Ausgangssignal (AS) unmittelbar abhängig sind, und
**dadurch gekennzeichnet, dass** über eine schaltbare Einstellvorrichtung (8), deren Schaltzustand von dem Ausgangssignal (AS) unabhängig ist, die Höhe der Signalspannung (Ss) steuerbar und/oder eine Kennlinie für die Signalspannung (Ss) veränderbar ist, indem durch die Einstellvorrichtung (8) ein durch den Integrierer (6) vorgegebener Verstärkungsfaktor zwischen dem am Ausgang (2.4) der monostabilen Kippschaltung (2) erzeugten Ausgangssignal (AS) und der über die Umwandlungseinrichtung erzeugten Signalspannung (Ss) einstellbar ist.

2. Schaltungsanordnung nach Anspruch 1, **dadurch gekennzeichnet, dass** über die schaltbare Einstellvorrichtung (8) mehrere diskrete Werte für den Verstärkungsfaktor vorgegeben und auswählbar sind.

3. Schaltungsanordnung nach Anspruch 1 oder 2, **dadurch gekennzeichnet, dass** die Einstellvorrichtung (8) an einem Ausgang des Operationsverstärkers (60) vorgesehen ist und über die schaltbare Einstellvorrichtung (8) ein an den Operationsverstärker (60) zurückgeführter Strom variiert werden kann.

4. Schaltungsanordnung nach einem der Ansprüche 1 bis 3, **dadurch gekennzeichnet, dass** die Einstellvorrichtung (8) für die Steuerung der Höhe der Signalspannung (Ss) und/oder einer Veränderung der Signalspannung (Ss) wenigstens einen Feldeffekttransistor (81, 82) aufweist.

5. Schaltungsanordnung nach einem der vorhergehenden Ansprüche, **dadurch gekennzeichnet, dass** die monostabile Kippschaltung (2) derart ausgebildet ist, dass ihr Ausgangssignal (AS) zwei diskrete Spannungswerte annehmen kann.

6. Schaltungsanordnung nach einem der vorhergehenden Ansprüche, **dadurch gekennzeichnet, dass** das Ausgangssignal (AS) der monostabilen Kippschaltung (2)
- einen Minimalwert aufweist, der kleiner ist als ein Spannungswert einer Bezugsspannung, die an dem anderen Verstärkereingang (601) des Operationsverstärkers (60) anliegt, und
- einen Maximalwert aufweist, der größer ist als der Spannungswert der Bezugsspannung an dem anderen Verstärkereingang (601).

7. Schaltungsanordnung nach einem der vorhergehenden Ansprüche, **dadurch gekennzeichnet, dass** zum Betrieb des Operationsverstärkers (60) eine Versorgungsspannung (VCC) vorgesehen ist und die Schaltungsanordnung einen Spannungsteiler (R2, R3) aufweist, um eine Bezugsspannung, die an einem Verstärkereingang (601) des Operationsverstärkers (60) anliegt, als eine Teilspannung der Versorgungsspannung (VCC) bereitzustellen.

8. Schaltungsanordnung nach einem der vorhergehenden Ansprüche, **dadurch gekennzeichnet, dass** der Integrierer (6) invertierend ist.

9. Schaltungsanordnung nach einem der vorhergehenden Ansprüche, **dadurch gekennzeichnet, dass** dem Integrierer (6) ein Spitzenwerthalteglied (7, C2, R4) nachgeschaltet ist, um einen maximalen Spannungswert der Signalspannung (Ss) zu speichern.

10. Schaltungsanordnung nach Anspruch 9, **dadurch gekennzeichnet, dass** das Spitzenwerthalteglied (7, C2, R4) wenigstens eine Diode (7) und einen Speicherkondensator (C2) umfasst.

11. Schaltungsanordnung nach einem der vorhergehenden Ansprüche, **dadurch gekennzeichnet, dass** in der Auswerteeinheit (5) wenigstens ein Schwellwert für die Signalspannung (Ss) hinterlegt ist und die Auswerteeinheit (5) dazu ausgebildet ist, bei Über- oder Unterschreiten dieses Schwellwerts durch die Signalspannung (Ss) ein Auslösesignal zu erzeugen.

12. Verstellvorrichtung für ein verstellbares Schließelement eines Fahrzeugs, wobei
- über das Schließelement eine Karosserieöffnung eines Fahrzeugs verschließbar ist und das Schließelement bei Vorliegen eines Bedienereignisses automatisch verstellt und/oder zum Freigeben der Karosserieöffnung eine Verriegelung des Schließelements betätigt werden kann, und
- eine kapazitiv arbeitende Sensoreinrichtung mit wenigstens einem kapazitiven Bauelement vorgesehen ist, um das Vorliegen eines Bedienereignisses anhand der Kapazität des Bauelements und/oder einer Änderung der Kapazität des Bauelements zu erkennen,
**dadurch gekennzeichnet, dass**
die Verstellvorrichtung zur Erfassung der Kapazität des kapazitiven Bauelements und/oder einer Änderung der Kapazität des kapazitiven Bauelements eine Schaltungsanordnung nach einem der Ansprüche 1 bis 11 umfasst.

13. Verfahren zur Erfassung einer Kapazität eines kapazitiven Bauelements und/oder einer Änderung der Kapazität eines kapazitiven Bauelements, mit folgenden Schritten:
- Steuern einer monostabilen Kippschaltung (2) durch Anlegen eines Steuerungssignals an einen ersten Eingang (2.1) der monostabilen Kippschaltung, wobei die monostabile Kippschaltung (2) an einem zweiten Eingang (2.3) mit dem kapazitiven Bauelement (3) verbunden ist,
- Erzeugen wenigstens eines Ausgangssignals (AS) an einem Ausgang (2.4) der monostabilen Kippschaltung (2) bei Anlegen des Steuerungssignals, wobei die Zeitdauer des erzeugten Ausgangssignals (AS) von der Kapazität des kapazitiven Bauelements (3) abhängig ist, und
- Umwandeln des wenigstens einen Ausgangssignals (AS) in eine Signalspannung (Ss), deren Verlauf zu der Zeitdauer des Ausgangssignals (AS) proportional ist,
wobei das Umwandeln des Ausgangssignals (AS) mittels eines Integrierers (6) erfolgt, der einen Operationsverstärker (60) aufweist, an dessen einem Verstärkereingang (602) das Ausgangssignal (AS) anliegt, und der das Ausgangssignal (AS) der monostabilen Kippschaltung (2) zu einer sich linear mit der Zeit verändernden Signalspannung (Ss) umwandelt, so dass die Werte, die die Signalspannung (Ss) annehmen kann, durch das Ausgangssignal (AS) vorgegeben und von dem Ausgangssignal (AS) unmittelbar abhängig sind, und
**dadurch gekennzeichnet, dass** über eine schaltbare Einstellvorrichtung (8), deren Schaltzustand von dem Ausgangssignal (AS) unabhängig ist, die Höhe der Signalspannung (Ss) steuerbar und/oder eine Kennlinie für die Signalspannung (Ss) veränderbar ist, indem durch die Einstellvorrichtung (8) ein durch den Integrierer (6) vorgegebener Verstärkungsfaktor zwischen dem am Ausgang (2.4) der monostabilen Kippschaltung (2) erzeugten Ausgangssignal (AS) und der über die Umwandlungseinrichtung erzeugten Signalspannung (Ss) einstellbar ist.

## Claims

1. A circuit arrangement for detecting a capacitance of a capacitive component and/or a change in the capacitance of a capacitive component, comprising
- a monostable flipflop (2) controllable by a control signal and having at least two inputs (2.1, 2.3) and one output (2.4), wherein a first input (2.1) of the flipflop (2) is provided for the control signal,
- a capacitive component (3), which is connected to a second input (2.3) of the monostable flipflop (2),
- a conversion device, which is connected to the output (2.4) of the monostable flipflop (2) and is designed and intended for converting an output signal (AS) generated at the output (2.4) into a signal voltage (Ss), and
- an evaluation unit (5), which is connected to the conversion device in order to evaluate the signal voltage (Ss) and from this to generate at least one detection value, which indicates the capacitance and/or a change in the capacitance of the capacitive component (3),
wherein the monostable flipflop (2) is designed to generate at least one output signal (AS) at its output (2.4) on actuation by a control signal, the duration of said output signal being dependent on the capacitance of the capacitive component (3), and the conversion device converts the at least one output signal (AS) into a signal voltage (Ss), whose course is proportional to the duration of the output signal (AS),
wherein the conversion device comprises an integrator (6) having an operational amplifier (60), and the integrator (6) is designed and connected between the output (2.4) of the monostable flipflop (2) and the evaluation unit (5) in such a way that an output signal (AS) of the monostable flipflop (2) is present at an amplifier input (602) of the operational amplifier (60) and results in a signal voltage (Ss) which changes linearly over time, wherein the values which can be assumed by the signal voltage (Ss) are preset by the output signal (AS) and dependent directly from the output signal (AS),
**characterized in that**
the magnitude of the signal voltage (Ss) is controllable and/or a characteristic for the signal voltage (Ss) is variable via a switchable setting device (8) whose switching state is independent from the output signal (AS), the magnitude of the signal voltage (Ss) being controllable and/or the characteristic for the signal voltage (Ss) being variable by setting a gain of the integrator (6) between the output signal generated at the output (2.4) of the monostable flipflop (2) and the signal voltage (Ss) generated via the conversion device (8).

2. The circuit arrangement according to Claim 1, **characterized in that** a plurality of discrete values for the gain are preset and selectable via a switchable setting device (8).

3. The circuit arrangement according to Claim 1, **characterized in that** the setting device (8) is provided at an output of the operational amplifier (60) and a current fed back to the operational amplifier (60) can be varied by the switchable setting device (8).

4. The circuit arrangement according to Claim 1 to 3, **characterized in that** the setting device (8) having at least one field-effect transistor (81, 82) for controlling the magnitude of the signal voltage (Ss) and/or a change in the signal voltage(Ss).

5. The circuit arrangement according to one of the preceding claims, **characterized in that** the monostable flipflop (2) is designed in such a way that its output signal (AS) can assume two discrete voltage values.

6. The circuit arrangement according to one of the preceding claims, **characterized in that** the output signal (AS) of the monostable flipflop (2)
- has a minimum value, which is less than a voltage value of a reference voltage which is present at the other amplifier input (601) of the operational amplifier (60), and
- has a maximum value which is greater than the voltage value of the reference voltage at the other amplifier input (601).

7. The circuit arrangement according to one of the preceding claims, **characterized in that,** for operation of the operational amplifier (60), a supply voltage (VCC) is provided and the circuit arrangement has a voltage divider (R2, R3) in order to provide a reference voltage which is present at an amplifier input (601) of the operational amplifier (60) as a partial voltage of the supply voltage (VCC).

8. The circuit arrangement according to one of the preceding claims, **characterized in that** the integrator (6) is inverting.

9. The circuit arrangement according to one of the preceding claims, **characterized in that** a peak value holding element (7, C2, R4) is connected downstream of the integrator (6) in order to store a maximum voltage value of the signal voltage (Ss).

10. The circuit arrangement according to Claim 9, **characterized in that** the peak value holding element (7, C2, R4) comprises at least one diode (7) and one storage capacitor (C2).

11. The circuit arrangement according to one of the preceding claims, **characterized in that** at least one threshold value for the signal voltage (Ss) is stored in the evaluation unit (5), and the evaluation unit (5) is designed to generate a tripping signal in the event that this threshold value is exceeded or undershot by the signal voltage (Ss).

12. A adjusting device for an adjustable closing element of a vehicle, wherein
- a vehicle body opening of a vehicle is closable via the closing element, and in the case of the presence of an operation event the closing element can be automatically adjusted and/or a locking device of the closing element can be actuated in order to clear the vehicle body opening, and
- a capacitively operating sensor device having at least one capacitive component is provided in order to identify the presence of an operation event on the basis of the capacitance of the component and/or a change in the capacitance of the component,
**characterized in that**
the adjusting device comprises a circuit arrangement according to one of Claims 1 to 11 for detecting the capacitance of the capacitive component and/or a change in the capacitance of the capacitive component.

13. A method for detecting a capacitance of a capacitive component and/or a change in the capacitance of a capacitive component, said method comprising the following steps:
- controlling a monostable flipflop (2) by applying a control signal to a first input (2.1) of the monostable flipflop, wherein the monostable flipflop (2) is connected to the capacitive component (3) at a second input (2.3),
- generating at least one output signal (AS) at an output (2.4) of the monostable flipflop (2) in the case of the application of the control signal, wherein the duration of the output signal (AS) generated is dependent on the capacitance of the capacitive component (3), and
- converting the at least one output signal (AS) into a signal voltage (Ss) whose course is proportional to the duration of the output signal (AS),
wherein the conversion of the output signal (AS) takes place by means of an integrator (6), which has an operational amplifier (60), which has the output signal (AS) present at an amplifier input (602) thereof, and which converts the output signal (AS) of the monostable flipflop (2) into a signal voltage (Ss) which changes linearly over time, so that the values which can be assumed by the signal voltage (Ss) are preset by the output signal (AS) and dependent directly from the output signal (AS),
**characterized in that**
the magnitude of the signal voltage (Ss) is controllable and/or a characteristic for the signal voltage (Ss) is variable via a switchable setting device (8) whose switching state is independent from the output signal (AS), the magnitude of the signal voltage (Ss) being controllable and/or the characteristic for the signal voltage (Ss) being variable by setting a gain of the integrator (6) between the output signal generated at the output (2.4) of the monostable flipflop (2) and the signal voltage (Ss) generated via the conversion device (8).

## Revendications

1. Ensemble formant circuit servant à détecter une capacité d'un composant capacitif et/ou une modification de la capacité d'un composant capacitif, avec
- un circuit bascule (2) monostable pouvant être commandé par un signal de commande avec au moins deux entrées (2.1, 2.3) et une sortie (2.4), dans lequel une première entrée (2.1) du circuit bascule (2) est prévue pour le signal de commande,
- un composant (3) capacitif, qui est relié à une deuxième entrée (2.3) du circuit bascule (2) monostable,
- un système de conversion, qui est relié à la sortie (2.4) du circuit bascule (2) monostable et est réalisé et prévu pour convertir un signal de sortie (AS) généré au niveau de la sortie (2.4) en une tension de signal (Ss), et
- une unité d'évaluation (5), qui est reliée au système de conversion pour évaluer la tension de signal (Ss) et générer sur cette base au moins une valeur de détection, qui indique la capacité et/ou une modification de la capacité du composant (3) capacitif,
dans lequel le circuit bascule (2) monostable est réalisé pour générer dans le cas d'un pilotage avec un signal de commande au moins un signal de sortie (AS) au niveau de sa sortie (2.4) dont la durée dépend de la capacité du composant (3) capacitif, et le système de conversion convertit l'au moins un signal de sortie (AS) en une tension de signal (Ss), dont la variation est proportionnelle à la durée du signal de sortie (AS),
dans lequel
le système de conversion comprend un intégrateur (6) avec un amplificateur opérationnel (60) et l'intégrateur (6) est réalisé et branché entre la sortie (2.4) du circuit bascule (2) monostable et l'unité d'évaluation (5) de telle sorte qu'un signal de sortie (AS) du circuit bascule (2) monostable est appliqué au niveau d'une entrée d'amplificateur (602) de l'amplificateur opérationnel (60) et aboutit à une tension de signal (Ss) se modifiant linéairement avec le temps, dans lequel les valeurs, que la tension de signal (Ss) peut adopter, sont spécifiées par le signal de sortie (AS) et dépendent directement du signal de sortie (AS), et
**caractérisé en ce que**
l'ampleur de la tension de signal (Ss) peut être commandée et/ou une ligne caractéristique pour la tension de signal (Ss) peut être modifiée par l'intermédiaire d'un dispositif de réglage (8) pouvant être commuté, dont l'état de commutation ne dépend pas du signal de sortie (AS) **en ce qu'**un facteur d'amplification spécifié par l'intégrateur (6) entre le signal de sortie (AS) généré au niveau de la sortie (2.4) du circuit bascule (2) monostable et la tension de signal (Ss) générée par l'intermédiaire du système de conversion peut être réglée par le dispositif de réglage (8).

2. Ensemble formant circuit selon la revendication 1, **caractérisé en ce que** plusieurs valeurs discrètes sont spécifiées et peuvent être choisies pour le facteur d'amplification par l'intermédiaire du dispositif de réglage (8) pouvant être commuté.

3. Ensemble formant circuit selon la revendication 1 ou 2, **caractérisé en ce que** le dispositif de réglage (8) est prévu au niveau d'une sortie de l'amplificateur opérationnel (60) et un courant ramené à l'amplificateur opérationnel (60) peut être varié par l'intermédiaire du dispositif de réglage (8) pouvant être commuté.

4. Ensemble formant circuit selon l'une quelconque des revendications 1 à 3, **caractérisé en ce que** le dispositif de réglage (8) présente pour la commande de l'ampleur de la tension de signal (Ss) et/ou d'une modification de la tension de signal (Ss) au moins un transistor à effet de champ (81, 82).

5. Ensemble formant circuit selon l'une quelconque des revendications précédentes, **caractérisé en ce que** le circuit bascule (2) monostable est réalisé de telle manière que son signal de sortie (AS) peut adopter deux valeurs de tension discrètes.

6. Ensemble formant circuit selon l'une quelconque des revendications précédentes, **caractérisé en ce que** le signal de sortie (AS) du circuit bascule (2) monostable
- présente une valeur minimale, qui est inférieure à une valeur de tension d'une tension de référence, qui est appliquée au niveau de l'autre entrée d'amplificateur (601) de l'amplificateur opérationnel (60), et
- présente une valeur maximale, qui est supérieure à la valeur de tension de la tension de référence sur l'autre entrée d'amplificateur (601).

7. Ensemble formant circuit selon l'une quelconque des revendications précédentes, **caractérisé en ce que** pour faire fonctionner l'amplificateur opérationnel (60), une tension d'alimentation (VCC) est prévue et l'ensemble formant circuit présente un diviseur de tension (R2, R3) pour fournir en tant qu'une tension partielle de la tension d'alimentation (VCC) une tension de référence, qui est appliquée au niveau d'une entrée d'amplificateur (601) de l'amplificateur opérationnel (60).

8. Ensemble formant circuit selon l'une quelconque des revendications précédentes, **caractérisé en ce que** l'intégrateur (6) est inversant.

9. Ensemble formant circuit selon l'une quelconque des revendications précédentes, **caractérisé en ce qu'**un organe de maintien de valeur de pic (7, C2, R4) est branché en aval de l'intégrateur (6) pour mémoriser une valeur de tension maximale de la tension de signal (Ss).

10. Ensemble formant circuit selon la revendication 9, **caractérisé en ce que** l'organe de maintien de valeur de pic (7, C2, R4) comprend au moins une diode (7) et un condensateur accumulateur (C2).

11. Ensemble formant circuit selon l'une quelconque des revendications précédentes, **caractérisé en ce qu'**au moins une valeur de seuil pour la tension de signal (Ss) est enregistrée dans l'unité d'évaluation (5) et l'unité d'évaluation (5) est réalisée pour générer en cas de dépassement ou de valeur inférieure de ladite valeur de seuil par la tension de signal (Ss) un signal de déclenchement.

12. Dispositif d'ajustement pour un élément de fermeture ajustable d'un véhicule, dans lequel
- une ouverture de carrosserie d'un véhicule peut être fermée par l'intermédiaire de l'élément de fermeture et l'élément de fermeture ajuste automatiquement en présence d'un événement d'utilisateur et/ou un verrouillage de l'élément de fermeture peut être actionné pour dégager l'ouverture de carrosserie, et
- un dispositif de capteur à fonctionnement capacitif est prévu avec au moins un composant capacitif pour identifier la présence d'un événement d'utilisateur à l'aide de la capacité du composant et/ou d'une modification de la capacité du composant,
**caractérisé en ce que**
le dispositif d'ajustement servant à détecter la capacité du composant capacitif et/ou une modification de la capacité du composant capacitif comprend un ensemble formant circuit selon l'une quelconque des revendications 1 à 11.

13. Procédé servant à détecter une capacité d'un composant capacitif et/ou une modification de la capacité d'un composant capacitif, avec des étapes qui suivent :
- commande d'un circuit bascule (2) monostable en appliquant un signal de commande sur une première entrée (2.1) du circuit bascule monostable, dans lequel le circuit bascule (2) monostable est relié au niveau d'une deuxième entrée (2.3) au composant (3) capacitif,
- génération d'au moins un signal de sortie (AS) au niveau d'une sortie (2.4) du circuit bascule (2) monostable en appliquant le signal de commande, dans lequel la durée du signal de sortie (AS) généré dépend de la capacité du composant (3) capacitif, et
- conversion de l'au moins un signal de sortie (AS) en une tension de signal (Ss), dont la variation est proportionnelle à la durée du signal de sortie (AS),
dans lequel
la conversion du signal de sortie (AS) est effectuée au moyen de l'intégrateur (6), qui présente un amplificateur opérationnel (60), au niveau d'une entrée d'amplificateur (602) duquel le signal de sortie (AS) est appliqué et qui convertit le signal de sortie (AS) du circuit bascule (2) monostable en une tension de signal (Ss) se modifiant linéairement avec le temps de sorte que les valeurs, que la tension de signal (Ss) peut adopter, sont spécifiées par le signal de sortie (AS) et dépendent directement du signal de sortie (AS), et
**caractérisé en ce que**
l'ampleur de la tension de signal (Ss) peut être commandée et/ou une courbe caractéristique pour la tension de signal (Ss) peut être modifiée par l'intermédiaire d'un dispositif de réglage (8) pouvant être commuté, dont l'état de commutation ne dépend pas du signal de sortie (AS) **en ce qu'**un facteur d'amplification spécifié par l'intégrateur (6) entre le signal de sortie (AS) généré au niveau de la sortie (2.4) du circuit bascule (2) monostable et la tension de signal (Ss) générée par l'intermédiaire du système de conversion peut être réglée par le dispositif de réglage (8).
